# EUROPÄISCHE PATENTANMELDUNG

(11) **EP 1 610 399 A1**
(43) Veröffentlichungstag der Anmeldung: **28.12.2005**
(21) Anmeldenummer: 04090249.6
(22) Anmeldetag: 22.06.2004
(51) Int. Cl.: H01L 51/40, H01L 51/20

(54) **Substrat zum Tintenstrahldrucken und Verfahren zu dessen Herstellung**

(71) Anmelder: Samsung SDI Co., Ltd., Suwon-si, Gyeonggi-do (KR)
(72) Erfinder: Uhlig, Albrecht, Dr., 12524 Berlin (DE); Nolte, Kerstin, Dr., 10781 Berlin (DE)
(74) Vertreter: Hengelhaupt, Jürgen

(57) **Zusammenfassung**

Der vorliegenden Erfindung liegt daher Aufgabe zugrunde, ein Substrat zum Tintenstrahldrucken für ein OLED-Display sowie ein Verfahren zu dessen Herstellung anzugeben, welches kostengünstig herstellbar ist und eine hohe Auflösung für das OLED-Display sowie einen geringen elektrischen Widerstand für eine während der Herstellung des OLED-Displays aufzutragende Kathode ermöglicht.

Dazu weist das erfindungsgemäße Substrat ein Grundsubstrat (1) mit einer auf der Grundsubstratoberfläche angeordneten Struktur aus aktiven Bereichen (5) zur Aufnahme von organischem Material zur Ausbildung von Pixeln und aus passiven Bereichen zur Separation der Pixel auf, wobei mindestens ein Teil der passiven Bereiche eine Schicht aus der chemischen Klasse der Organosilane der allgemeinen Formel I

RₙSiX₄₋ₙ (I)

aufweist, wobei mindestens eine der Gruppen Rₙ eine hydrolisierbare Gruppe und X ein Wasserstoffatom ist.

## Beschreibung

Die Erfindung betrifft ein Substrat zum Tintenstrahldrucken und ein Verfahren zu dessen Herstellung gemäß den Oberbegriffen der Ansprüche 1 und 9.

Der Tintenstrahldruckprozess ist einer der wichtigsten Strukturierungsprozesse für die Herstellung von Vollfarbdisplays auf der Basis lichtemittierender, halbleitender Polymere (LEPs). Dabei werden kleine Tropfen einer Lösung des entsprechenden Polymers auf ein geeignetes Substrat aufgebracht. Der Tintenstrahldruckprozess wird jedoch auch in anderen technischen Bereichen, beispielsweise zum Aufbringen von Farbfiltern oder DNA-Sensoren auf ein Substrat verwendet.

All diese Anwendungen verlangen eine genaue Plazierung der aufzutragenden Stoffe (Tinte) auf einer vorher festgelegten aktiven Fläche. Tintenstrahldrucktechnik ist bekannt als eine der diesen Ansprüchen genügenden Technologie. Beim Tintenstrahldrucken wird durch das Lösen der aktiven, aufzutragenden Substanz in einer Hilfssubstanz eine Tinte hergestellt. Diese Tinte wird anschließend in kleinen Mengen in Tropfenform auf das zu beschichtende Substrat z.B. durch Piezo- oder "Bubble jet"-Tintenstrahltechnik aufgebracht. Die genaue Positionierung des Tropfens auf dem Substrat wird unter anderem durch mechanisches Positionieren des Tintenstrahlkopfes relativ zum Substrat realisiert. Nach dem Verdampfen der Hilfssubstanz bildet die aktive Substanz einen Film auf der aktiven Fläche des Substrates.
Einer der häufigsten beim Bedrucken auftretenden Fehler ist das Auslaufen des Tropfens aus der aktiven Fläche in benachbarte Flächen des Substrates. Für den Anwendungsfall der Anzeigenelemente auf Basis organischer Leuchtdioden (OLED) bedeutet dies ein Vermischen von Farben, da hier rot, grün oder blau emittierende Bereiche in unmittelbarer Nachbarschaft zueinander angeordnet sind.

OLED-Anzeigenelemente sind seit den späten 80ziger Jahren des letzten Jahrhunderts bekannt. Man unterscheidet zwischen polymeren OLED (PLED) und niedermolekularen OLED (SM-OLED). WO 00/76008A1 (CDT) beschreibt grundlegend den Aufbau eines PLED-Anzeigenelementes.
US4539507, US4885211 (Eastman-Kodak) beschreiben den prinzipiellen Aufbau eines SM-OLED, in dem ALQ₃ (Tris-(5-chloro-8-hydroxy-quinolinato)-aluminium) als lichtemittierendes und elektronentransportierendes Material beschrieben ist.

Das Grundprinzip welches den OLED-Bauelementen zugrunde liegt, ist die Elektrolumineszenz. Hier werden durch geeignete Kontakte Elektronen und Löcher in ein halbleitendes Material injiziert. Bei der Rekombination dieser Ladungsträger entsteht Licht.

Piezo-Tintenstrahldrucktechnik ist eine der wichtigsten Strukturierungstechnologien in der Herstellung von auf polymeren OLED basierenden Vollfarbendisplays und beispielsweise aus US 2002/004126 bekannt. Hier werden kleine Tropfen von einer die aktive Substanz (lochtransportierende oder lichtemittierende Materialien) enthaltenden Lösung auf der aktiven Fläche eines geeigneten Substrates aufgetragen. Die Dimension dieser aktiven Flächen (einzelner Bildpunkt/-Pixel) für ein hochauflösendes Anzeigenelement, wie es zum Beispiel in modernen Mobiltelephonen zum Einsatz kommt, liegt im Bereich von 40 µm x 180 µm.

Dem Stand der Technik entsprechende Tintenstrahlköpfe können Tintentropfen mit einem Durchmesser von größer 30 µm erzeugen. Somit ist der Tropfendurchmesser im gleichen Größenbereich wie der zu beschichtende Bildpunkt. Um ein Überlaufen des Tropfens zu verhindern, wird die Oberfläche des Substrates durch geeignete Maßnahmen gestaltet.

### Grundlegend werden zwei Strategien verfolgt:

Erstens wird eine Substratoberfläche derart erzeugt, dass Bereiche mit unterschiedlichen Oberflächenenergien und somit mit unterschiedlichen Bedeckungseigenschaften für die Tinte entstehen. Eine zweite Möglichkeit besteht darin, geometrische (mechanische) Barrieren zu verwenden, um ein Überfließen des Tropfens zu verhindern.

Einer der grundlegenden Lösungsansätze wird in EP 0989778 A1 (Seiko-Epson) beschrieben. Es wird durch geeignete Auswahl der Materialien, welche die Substratoberfläche bilden, ein Kontrast der Oberflächenenergie geschaffen. Die aufgedruckte Tinte kann nur in Bereichen mit hoher Oberflächenenergie verlaufen, während Bereiche mit niedriger Oberflächenenergie als Barriere wirken. Um eine homogene Schichtdicke des Films zu erhalten, ist es weiterhin von Vorteil, über den Rand der Pixelfläche der organischen Leuchtdiode (OLED) hinaus hohe Oberflächenenergie einzustellen. Der sich ausbildende Film wird dann bis zur Randzone homogen und die Schichtdicke nimmt erst außerhalb der aktiven Zone in Nähe der Barriere merklich ab. Der nötige Kontrast der Oberflächenenergien kann auf verschiedene Art und Weise erreicht werden. EP 0989778 A1 (Seiko-Epson) beschreibt eine Zweischichtstruktur der Oberfläche. Durch geeignete Oberflächenbehandlung im Plasma kann die obere Schicht mit niedriger Oberflächenenergie versehen werden, während die untere Schicht aufgrund ihrer chemischen Natur durch die gleiche Behandlung hohe Oberflächenenergie erhält. Die untere Schicht wird typischerweise aus anorganischen Materialien wie Siliziumoxid/Nitrid hergestellt.

Die anorganische Schicht wirkt dabei als Randzone mit hoher Oberflächenenergie und erleichtert das Aufbringen homogener Polymerfilme durch den Tintenstrahldruckprozess.
Das Aufbringen und Strukturieren dieser Schicht erfordert allerdings Prozesse, die typischerweise in der Halbleiterindustrie verwendet werden. Für die Schichtabscheidung kommen Sputterprozesse und Gasphasenprozesse wie PECVD (Plasma Enhanced Chemical Vapour Deposition) in Frage. Diese Prozesse erfordern lange Taktzeiten und sind zudem kostenintensiv, wodurch der durch die OLED-Technologie gewonnene Kostenvorteil verringert wird. Außerdem beinhaltet die zweite Schicht die Ausbildung einer Oberflächentopographie, d.h. die Bereiche mit niedriger Oberflächenenergie (hier "Separatoren" genannt) heben sich mit endlicher Höhe von der Substratoberfläche ab. Durch dieses Höhenprofil kann der abgeschiedene Polymerfilm ein unerwünschtes Dickenprofil ausbilden, indem er sich zu in den Randbereichen an den Separatoren nach oben aufwölbt. Je nach den Dimensionen kann dieses Aufwölben bis in die Bildpunkte (Pixel) ragen.

Weiterhin nachteilig in EP 0989778 ist, dass ein Tintenreservoir als weiterer Überlaufschutz Anwendung findet. Die Strukturierung dieses Reserviors ist zeitaufwendig und erhöht die technologische Schwierigkeit durch Hinzufügen eines weiteren Prozessschrittes.

JP09203803 beschreibt die chemische Behandlung der Substratoberfläche, die zuvor mit einem Fotolack beschichtet wurde. Im Anschluß daran wird der Fotolack durch eine Maske belichtet und entwickelt. In der so entstandenen Struktur haben die Bereiche mit Fotolack niedrige Oberflächenenergie, während Bereiche ohne Fotolack hohe Oberflächenenergie aufweisen. Die Flanken der Lackstruktur weisen mittlere Oberflächenenergie auf und können dadurch zu einem gewissen Grad einen abrupten Übergang der Oberflächenenergien vermeiden. Eine Randzone mit frei wählbarer Oberflächenenergie und Geometrie stellen sie allerdings nicht dar. Dies ist insofern nachteilig, da das räumliche Auflösungsvermögen des Tintenstrahldruckprozesses durch Bereiche mit mittlerer Oberflächenenergie abnimmt. Ein weiterer Nachteil ist, dass nur ein und derselbe Fotolack verwendet werden kann. Somit kann ein Kontrast der Oberflächenenergien nicht durch den Einsatz verschiedener Materialien erzeugt werden, was die Anwendbarkeit einschränkt. Darüber hinaus stellt die beschriebene chemische Behandlung einen zeitaufwendigen Prozeßschritt dar, welcher zu einer hohen Fertigungszeit führt.

JP09230129 beschreibt eine zweistufige Behandlung der Oberfläche. Zuerst wird die gesamte Oberfläche mit niedriger Oberflächenenergie ausgestattet. Durch die Nachbehandlung ausgewählter Teile der Oberfläche mit kurzwelligem Licht wird in diesen Bereichen dann die Oberflächenenergie wieder erhöht. Der erreichbare Kontrast der Oberflächenenergie ist jedoch begrenzt und die nötige Belichtungszeit nicht kompatibel mit einer Massenproduktion.

DE 10236404.4 (Samsung SDI) beschreibt die Oberflächenfluorierung eines Fotolackes unter Benutzung eines CF4 enthaltenden Plasmaprozesses in Verbindung mit einem Lift-Off-Prozess zur Strukturierung. Der hier benötigte CVD-Prozess verursacht allerdings als Vakuum basierende Technik zusätzliche Kosten sowie zusätzlichen Zeitaufwand. Des Weiteren ist die durch den beschriebenen Prozess eingestellte Oberflächenenergie zeitlich nicht stabil, da die fluorierten Teile der Oberfläche in die Fotolackschicht eindiffundieren, um damit ein Gleichgewicht einzustellen. Ein anderer Nachteil dieses Prozesses ist, dass die mit Fluor modifizierte Oberfläche chemisch nicht gegen Säure enthaltende Lösungen wie PDOT:PSS stabil ist und durch diese weggewaschen wird.

DE 10343351.1 (Samsung SDI) beschreibt die Abscheidung einer hydrophoben Schicht wie Teflon zur Erzeugung einer die Tinte abstoßenden Funktion. Das Teflon wird mit Hilfe von CVD oder durch thermisches Verdampfen aufgebracht und mittels Lift-Off, Laserablation oder durch die Nutzung einer Schattenmaske strukturiert. Beide Techniken zur Aufbringung des Teflons sind Vakuumprozesse und verursachen daher zusätzliche Prozesskosten sowie Prozesszeit. Weiterhin besteht hier eine Limitierung für die Substratgröße. Ein weiterer Nachteil von DE 10334351.1 ist die thermische Instabilität der niederenergetischen Schicht. Das in der Erfindung genannte Teflon hat die Tendenz, unter Normaldruck bei Temperaturen um 150 °C zu verdampfen.

US 6656611 (Osram OS) beschreibt die Nutzung von auf Polysiloxan basierenden Fotolacken als isolierendes Material zur Strukturierung der aktiven Fläche eines Displays. Das Polysiloxan wird bevorzugt als "überhängende Struktur" strukturiert um die Kathode von passiv Matrix Displays zu separieren. Da die Polysiloxanschicht allerdings eine beträchtliche Schichtdicke aufweist, wird der Kathodenschichtwiderstand durch die Separation des Metallfilms an den Kanten der Polysiloxanschicht negativ beeinflusst.

Als zweite Möglichkeit, ein Überfließen eines Tropfens zu verhindern, sind geometrische (mechanische) Barrieren beschrieben.

US 6,388,377 B1 beschreibt die Verwendung von Fotolack-Streifenstrukturen, die zwischen zwei benachbarten Bildpunkten positioniert sind. Diese Fotolackstreifen haben eine Höhe von > 2 µm und wirken gegenüber dem Tintentropfen als physische Barriere und verhindern damit ein Überlaufen. Die Herstellung dieser Fotolackstrukturen wird in EP 0996314 A1 beschrieben. Jeweils zwei parallel zueinander angeordnete Fotolackstrukturen (so genannte "banks") bilden einen Kanal, in dessen Mitte Bildpunkte liegen, welche später gleichfarbig emittieren (Rot, Grün oder Blau). Durch das Drucken einer geeigneten Tinte in diesen Kanal wird eine Beschichtung dieser Bildpunkte mit aktivem Material realisiert, während die Fotolackstrukturen gleichzeitig ein Überlaufen zu Bildpunkten verhindern, die außerhalb des Kanals liegen. Die Höhe der Banks ist größer als 0.5 x (Breite des Bildpunktes/ Durchmesser des Tropfens). Die Höhe ist weiterhin größer als die Filmdicke des durch Tintenstrahldrucktechnik abgeschiedenen aktiven Materials. Eine Feinstrukturierung der Banks wird dadurch erreicht, dass auf den Banks runde, ovale oder dreieckige Einkerbungen aufgebracht werden, die als Überflussreservoir dienen. Nachteilig ist es jedoch, dass die Höhe der Banks zu einer Qualitätsverminderung einer in einem nachfolgenden Technologieschritt erfolgenden Metallabscheidung führt. In dieser Metallabscheidung wird durch thermisches Verdampfen oder Sputtern die Kathode des OLED Bauelementes gebildet. Aufgrund der Form und Höhe der Fotoresiststrukturen erfolgt eine Unterbrechung oder zumindest eine dünnere Anscheidung des Metallfilms insbesondere an den Seitenwänden der "banks". Diese führt zu einem erhöhten elektrischen Widerstand, welcher sich nachteilig auf die Leistungsaufnahme des Anzeigenelementes auswirkt.

DE 103 11 097.6 beschreibt die Verwendung von zusätzlichen Tintenstoppern.

Da die Kanalstrukturen gemäß US 6,388,377 B1 am oberen und unteren Ende offen sind und nur in lateraler Richtung ein Überfließen der Tinte verhindern, kann die Tinte entlang der Kanäle ungehindert fließen und somit an den Enden der Kanäle auch aus diesen herausfließen. Dadurch ist das Tintenvolumen an den und Enden der Kanäle geringer als in der Mitte, wodurch eine inhomogene Schichtdickenverteilung der getrockneten lochleitenden Schicht und Polymerschicht entlang der Kanäle entsteht, was sich auch deutlich in der Elektrolumineszenz zeigt. Die oben genannten Tintenstopper sollen das Auslaufen der flüssigen Tinte aus dem oberen und unteren Ende der Kanalstrukturen verhindern.

US20030042849 (SEL) beschreibt einen weiteren Ansatz zur definierten Tropfenpositionierung und Filmbildung bei durch Tintenstrahldrucktechnik hergestellten Displays. Hier wird eine mechanische Maske positioniert und auf dem Substrat positioniert, so dass der organische Emitter durch Spincoating Technik aufgebracht werden kann. Allerdings hat die Nutzung von Metallschattenmasken eine Grenze in der Größe der zu beschichtenden Substrate. Unterschiedliche Ausdehnungskoeffizienten sowie nicht perfekt planare Masken oder Substrate verursachen einen Versatz bei größeren Substraten.

Zusammenfassend lässt sich sagen, dass die Herstellung der im Stand der Technik vorgeschlagenen Substrate entweder zu zeitaufwändig bzw. kostenintensiv ist oder die Kathodenabscheidung (aufgrund der Höhe der "banks") zu einem zu hohen elektrischen Widerstand führt oder das Substrat (aufgrund der Verwendung von Masken), insbesondere bei größeren Substraten, einen unerwünschten Versatz aufweist.

Der vorliegenden Erfindung liegt daher die Aufgabe zugrunde, ein Substrat zum Tintenstrahldrucken für ein OLED-Display anzugeben, welches kostengünstig herstellbar ist und eine hohe Auflösung für das OLED-Display sowie einen geringen elektrischen Widerstand für eine während der Herstellung des OLED-Displays aufzutragende Kathode ermöglicht. Insbesondere sollen kostenintensive Herstellungsprozesse wie Vakuumprozesse (Verdampfen) sowie die Verwendung von Masken, welche insbesondere bei größeren Substraten zu einem unerwünschten Versatz führen, vermieden werden.
Es soll ein Verfahren zur Herstellung eines Substrates für ein OLED-Display angegeben werden, welches trotz hoher Auflösung für das OLED-Display und einem hohen Kontrast der Oberflächenenergien kostengünstig sowie in kurzer Fertigungszeit herstellbar ist.

Die Aufgaben werden erfindungsgemäß gelöst durch die Merkmale im kennzeichnenden Teil des Anspruchs 1 (Sachanspruch) sowie des Anspruchs 9 (Verfahrensanspruch) im Zusammenwirken mit den Merkmalen im Oberbegriff. Zweckmäßige Ausgestaltungen der Erfindung sind in den Unteransprüchen enthalten.

Der vorliegenden Erfindung liegt die Idee zugrunde, durch den Einsatz von selbstorganisierenden Strukturen auf dem erfindungsgemäßen Substrat Bereiche mit niedriger Oberflächenenergie, und somit einen entsprechenden Kontrast der Oberflächenenergie zu erzeugen. Dabei besteht die Substratoberfläche des erfindungsgemäßen Substrats einerseits aus aktiven Bereichen zur Aufnahme von organischem (Emitter-) Material zur Ausbildung von Bildpunkten (Pixeln) und passiven Bereichen zur Separation der Pixel. Die passiven Bereiche trennen bzw. separieren die einzelnen aktiven Bereiche voneinander und gewährleisten somit, dass sich die unterschiedlichen Tinten für die einzelnen Farben (rot, grün, blau) während des Bedruckens des Substrats mit organischem Emittermaterial (Tintenstrahldruck) nicht vermischen.

Erfindungsgemäß weist mindestens ein Teil der passiven Bereiche des Substrates eine Schicht aus der chemischen Klasse der Organosilane der allgemeinen Formel I

RₙSiX₄₋ₙ (I)

auf, wobei mindestens eine der Gruppen Rₙ eine hydrolisierbare Gruppe und X ein Wasserstoffatom ist.

In einer bevorzugten Ausführungsvariante sind die aktiven Bereiche zumindest teilweise mit einer Schicht aus Indium-Zinnoxid bedeckt. Die hydrolisierbare Gruppe R besteht vorzugsweise aus einem Halogen, einem Alkooxid, einem Alkyloxid oder aus einem Amin. In einer bevorzugten Ausführungsvariante ist die Schicht aus der chemischen Klasse der Organosilane kovalent an das Grundsubstrat gebunden. In einer weiteren, bevorzugten Ausführungsvariante ist die Oberflächenenergie der Schicht aus Organosilan mittels einer chemischen Modifikation abgesenkt. Vorzugsweise werden zur Absenkung/Herabsetzung der Oberflächenenergie ein oder mehrere Wasserstoffreste durch Fluor oder Fluorkohlenwasserstoffketten substituiert. Hierdurch ist es möglich, dass die Schicht aus Organosilan einer Oberflächenenergie kleiner als 40 mJ/m² aufweist. Vorzugsweise wird die Schicht aus Organosilan unter Verwendung 1H,1H,2H,2H-Perfluorooctyltriethoxysilane oder (Heptadecafluoro-1,1,2,2-tetrahydrodecyl)dimethyl-chlorosilane erzeugt.

Das erfindungsgemäße Verfahren zur Herstellung eines Substrates zum Tintenstrahldrucken ist durch das Aufbringen einer nichtkontinuierlichen Schichtstruktur aus der chemischen Klasse der Organosilane der allgemeinen Formel RₙSiX₄₋ₙ gekennzeichnet, wobei diese Schicht zumindest auf einem Teil der passiven Bereiche angeordnet wird. Hierdurch werden auf dem Substrat passive Bereiche niedriger Oberflächenenergie erzeugt, die derart strukturiert werden, dass sie die aktiven Bereiche (Flächen), auf denen die Bildpunkte angeordnet werden, voneinander separieren. Durch die niedrige Oberflächenenergie der passiven Bereiche wird ein entsprechender Kontrast der Oberflächenenergie erzielt.

Die Schicht aus Organosilan wird vorzugsweise nasschemisch aufgebracht. In einer bevorzugten Ausführungsvariante des erfindungsgemäßen Verfahrens wird die Oberflächenenergie der Organosilanschicht mittels einer chemischen Modifikation abgesenkt. Vorzugsweise werden dazu ein oder mehrere Wasserstoffreste durch Fluor oder Fluorkohlenwasserstoffketten substituiert.

Eine Strukturierung der Organosilanschicht kann vorzugsweise mittels eines Lift-Off-Prozesses realisiert werden. Zu diesem Zweck wird die Grundsubstratfläche mit einem Standardfotolack bedeckt und in der Weise strukturiert, dass die aktiven Flächen bedeckt und die passiven Flächen nicht bedeckt sind. Das derart strukturierte Substrat wird dann der Organosilanlösung ausgesetzt und anschließend wird der Fotolack und damit auch die im Bereich des Fotolacks befindliche Organosilanschicht entfernt, wodurch sich eine nichtkontinuierliche Organosilanschicht in den passiven Bereichen ausbildet.

Vorteilhafterweise lässt sich mit der erfindungsgemäßen Struktur nach der Erfindung ein Substrat mit einem hohen Kontrast in der Oberflächenenergie sehr kostengünstig herstellen.

Die Organosilanschicht wird vorteilhafterweise auf nasschemischem Wege aufgebracht. Dies gewährleistet niedrige Prozesskosten. Die Lösung kann mehrere Male genutzt und nach Lösungsmittelrecycling und Zugabe von aktivem Material (Organosilan) in benötigter Konzentration wiederverwendet werden. Eine Vakuumtechnologie ist hier nicht nötig.
Zusätzlich dazu können weitere benötigte Prozessschritte wie die nasschemische Substratreinigung ohne Änderung des Kontrastes der Oberflächenenergien durchgeführt werden.
Aufgrund der kovalenten Bindung der Organosilane an das Substrat ist die Schicht thermisch deutlich stabiler als z.B. eine Teflonschicht, was für nachfolgende Prozessschritte wichtig ist.

Die sehr geringe Höhe der abstoßenden Schicht (im Bereich von Monolagen) erlaubt das Design eines Substrates für die Tintenstrahldrucktechnik mit sehr geringem Profil. Diese Eigenschaft wirkt sich aufgrund eines sehr geringen Kathodenwiderstandes vorteilhaft auf die Leistungsaufnahme einer Aktivmatrix OLED aus. Die derzeit standardmäßig benutzten Oberflächen für tintenstrahlgedruckte Bauelemente haben Profile mit Höhendifferenzen von einigen 100nm bis zu einigen µm. Diese Kanten verursachen inhomogene Metallkathodenfilme während der Kathodenpräparation (thermisches Verdampfen oder Sputtern). Die Abscheidung des Metalls an diesen Kanten ist gestört. Die Kathodenschicht ist dünner, oder sie reißt im schlimmsten Falle ganz ab. Dies ist gewöhnlich der Fall für Substrate mit Kantenprofilen mit Höhen von mehr als 300 nm. Dadurch wird der Ohm'sche Widerstand der Kathode erhöht, was schließlich zur erhöhten Leistungsaufnahme führt. Im schlimmsten Fall tritt eine Fehlfunktion des Bauelementes auf.
Die sehr geringe Breite des Organosilan-Films ist sehr vorteilhaft für hochauflösende Bauelemente und für die Erzeugung flacher Filme. Dies liegt darin begründet, dass der Abstand, der zur Abgrenzung zweier aktiver Flächen und damit zur Vermeidung eines Überfließens der Tinte benötigt wird, deutlich reduziert werden kann. Im Fall der Verwendung von Photolackstrukturen als Separatoren beträgt die minimale Breite aufgrund von Stabilitätsgründen etwa 10 µm und ist in der Regel größer. Bei der vorliegenden Erfindung hingegen ist die minimale Breite durch die Auflösung der Lithographie, mit der die Lift off Strukturen definiert werden, oder durch die ansonsten verwendete Strukturierungsmethode begrenzt. Hierdurch ist eine minimale Breite kleiner als 10 µm realisierbar. Der Platz, der durch die vorliegende Erfindung gespart werden kann, kann zur Erhöhung der Auflösung und/oder zur Erhöhung des Füllfaktors (Verhältnis von aktiver Fläche eines Pixels zur gesamten Pixelfläche) und/oder zur Reduzierung der Schichtdickenvariationen des tintenstrahlgedruckten Materials genutzt werden. Letzterer Effekt wird durch das Trocknungsverhalten der Tinte an Grenzflächen mit starkem Kontrast in den Oberflächenenergien verursacht.
Die Wahl des Materials mit niedriger Oberflächenenergie aus der Klasse der Organischen Materialien erlaubt eine einfache standardmäßige Strukturierungstechnologie. Dies steht im Gegensatz zu Ansätzen, in denen inorganische Schichten wie SiO₂ zur Erzeugung von Flächen mit hoher Oberflächenenergie eingesetzt werden.

Zusammenfassend sind die Vorteile der vorliegenden Erfindung folgende:
- Die Erzeugung einer Oberfläche für Tintenstrahldrucktechnologien mit hohem Kontrast in den Oberflächenenergien durch die Wahl von Materialien, welche eine vordefinierte Oberflächenenergie besitzen
- Die Vermeidung der Verwendung anorganischer Materialien mit aufwändigeren Strukturierungstechnologien
- Die einfache nasschemische Depositionstechnologie, welche geringe Prozesskosten erlaubt.
- Die Vermeidung eines Vakuumprozesses zur Einstellung des Kontrastes der Oberflächenenergien
- Die Vermeidung jeglicher weiterer Oberflächenbehandlungen zur Erzeugung des Kontrastes der Oberflächenenergien
- Die Stabilität der Oberflächeneigenschaften gegen thermische Behandlung
- Die Verwendung eines Schichtsystems mit niedrigem Oberflächenprofil zur Vermeidung von Kathodenseparationseffekten
- Die Verwendung eines Schichtsystems mit geringer Breite zwischen den aktiven Flächen und damit die Ermöglichung von
- Hochauflösendem Drucken und/oder
- Größerem Füllfaktor z.B. für OLEDs oder gedruckte Farbfilter und/oder
- Höhere Schichtdickenhomogenität in der aktiven Fläche z.B. für OLEDs oder gedruckte Farbfilter.

Die Erfindung soll nachfolgend in einem Ausführungsbeispiel anhand der Figuren näher erläutert werden. Es zeigen:
- Figur 1: ein Grundsubstrat mit aktiven Flächen, welche durch Indium-Zinnoxid bedeckt sind in schematischer, geschnittener Darstellung,
- Figur 2: das Grundsubstrat nach Figur 1, welches zur Strukturierung einer Organosilanschicht bereits mit einer strukturierten Fotolackschichtstruktur versehen ist,
- Figur 3: das Substrat nach Figur 2 nach Aufbringen einer kontinuierlichen Organosilanschicht und
- Figur 4: das erfindungsgemäße Substrat nach Ablösen der Fotolackschicht in schematischer, geschnittener Darstellung.

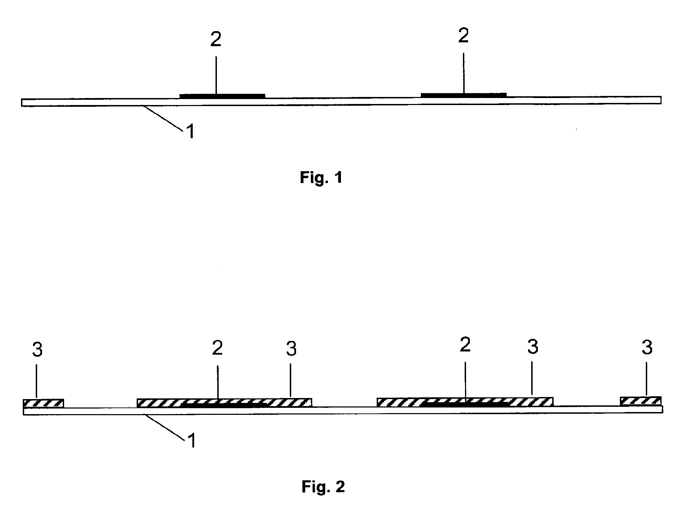

Zur Herstellung eines erfindungsgemäßen Substrats wird ein mit 100 nm Indium-Zinnoxid (ITO) 2 beschichtetes Borsilikat-Glas (Dicke 1,1 mm) als Grundsubstrat 1 verwendet. Das ITO 2 ist derart strukturiert, dass zueinander parallele, 2 mm breite ITO-Streifen 2 erzeugt werden, wie in Figur 1 schematisch dargestellt ist.
In einem nächsten Schritt wird auf dieses Substrat ein 0,3 µm dicker Fotolack 3 (JEM 750) durch Standardtechnologien aufgebracht. Dieser Fotolack 3 wird durch Standardtechnologien derart strukturiert, dass die späteren aktiven Flächen (Pixel), die nicht mit Organosilan bedeckt werden sollen, mit dem Fotolack 3 bedeckt sind, wie in Figur 2 schematisch dargestellt ist.

In einem nächsten Schritt wird das Substrat gereinigt. Die Reinigung erfolgt für 5 Minuten in einem Ultraschallbad mit Isopropanol und nach dem Trocknen durch Abblasen mit Stickstoff erfolgt eine UV-Ozon Behandlung für 10 Minuten.

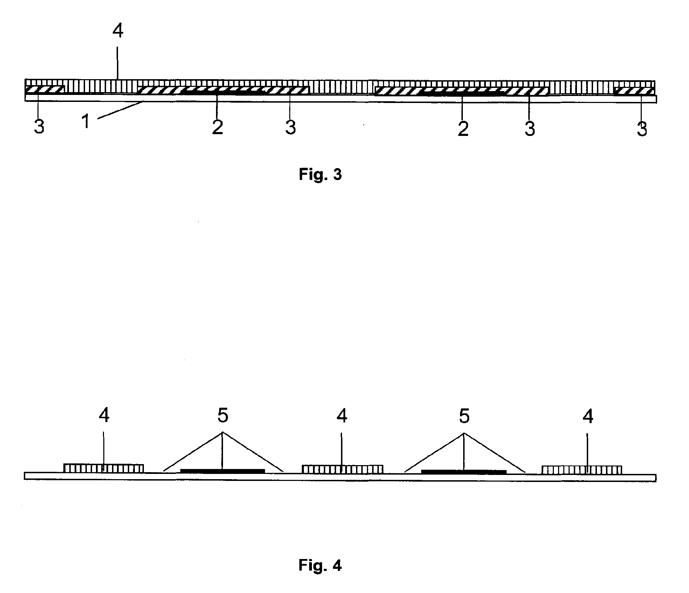

In einem weiteren Schritt wird die Organosilanschicht 4 hergestellt (Figur 3). Dazu wird 1H,1H,2H,2H-Perfluoroctyltriethoxysilane C₁₄H₁₉F₁₃O₃Si (Gelest, Inc.) in Ethanol von Roth (> 96 %, DAB) mit einer Konzentration von 10 % gelöst. Nach 5 Minuten Rühren wird das gereinigte und mit UV-Ozon behandelte Substrat in die Lösung getaucht. Während die Lösung weiter gerührt wird verbleibt das Substrat für 5 Minuten in der Lösung. Nach dem Trocknen an der Luft wird als Substrat für 30 Minuten bei 160 °C auf einer Heizplatte an Luft getempert.
Alternativ kann die Organosilanschicht 4 wie folgt aufgebracht werden:
(Heptadecafluoro-1,1,2,2-tetrahydrodecyl)dimethylchlorosilane C₁₂H₁₀ClF₁₇Si (Gelest, Inc.) wird in Ethanol von Roth (> 96 %, DAB) mit einer Konzentration von 10 % gelöst.

Nach 5 Minuten Rühren wird das gereinigte und mit UV-Ozon behandelte Substrat in dei Lösung getaucht. Während die Lösung weiter gerührt wird, verbleibt das Substrat für 5 Minuten in der Lösung. Nach dem Trocknen an der Luft wird das Substrat für 30 Minuten bei 160 °C auf einer Heizplatte an der Luft getempert.

In einem nächsten Schritt werden die Fotolackstrukturen 3 mit einem geeigneten Lösungsmittel (Tetrahydrofuran, THF) entfernt. Dadurch wird die kontinuierliche Organosilanschicht 4 (Figur 3) lediglich an denjenigen Flächen entfernt, auf welchen Fotolack 3 angeordnet war. Hierdurch bildet sich eine nichtkontinuierliche Organosilanstruktur 4 (Figur 4) aus, welche die aktiven Flächen 5 voneinander separiert.
Das so beschriebene Substrat kann nun mit Hilfe der Tintenstrahldrucktechnik beschichtet werden.

### Bezugszeichenliste

- 1: Grundsubstrat
- 2: Indium-Zinnoxid
- 3: Fotolack
- 4: Organosilanschicht
- 5: aktive Bereiche des Substrats

## Patentansprüche

1. Substrat zum Tintenstrahldrucken bestehend aus einem Grundsubstrat (1) mit einer auf der Grundsubstratoberfläche angeordneten Struktur aus aktiven Bereichen (5) zur Aufnahme von organischem Material zur Ausbildung von Pixeln und aus passiven Bereichen zur Separation der Pixel, **dadurch gekennzeichnet, dass**
mindestens ein Teil der passiven Bereiche eine Schicht (4) aus der chemischen Klasse der Organosilane der allgemeinen Formel I
RₙSiX₄₋ₙ (I)
aufweist, wobei mindestens eine der Gruppen Rₙ eine hydrolisierbare Gruppe und X ein Wasserstoffatom ist.

2. Substrat nach Anspruch 1, **dadurch gekennzeichnet, dass** das Grundsubstrat (1) Glas, Indium-Zinnoxid, Siliziumoxynitrid und/oder Fotolack aufweist.

3. Substrat nach Anspruch 1 oder 2, **dadurch gekennzeichnet, dass** die aktiven Bereiche (5) zumindest teilweise mit einer Schicht Indium-Zinnoxid bedeckt sind.

4. Substrat nach einem der vorhergehenden Ansprüche, **dadurch gekennzeichnet, dass** die hydrolisierbare Gruppe R aus einem Halogen, Alkoxid, Alkyloxid oder einem Amin besteht.

5. Substrat nach einem der vorhergehenden Ansprüche, **dadurch gekennzeichnet, dass** die Schicht (4) aus der chemischen Klasse der Organosilane kovalent an das Grundsubstrat (1) gebunden ist.

6. Substrat nach einem der vorhergehenden Ansprüche, **dadurch gekennzeichnet, dass** die Oberflächenenergie der Schicht (4) aus Organosilan mittels einer chemischen Modifikation abgesenkt ist.

7. Substrat nach Anspruch 7, **dadurch gekennzeichnet, dass** die Oberflächenenergie der Schicht (4) aus Organosilan kleiner als 40 mJ/m² ist.

8. Substrat nach einem der vorhergehenden Ansprüche, **dadurch gekennzeichnet, dass** die Schicht (4) aus Organosilan unter Verwendung von 1H,1H,2H,2H-Perfluorooctyltriethoxysilane oder (Heptadecafluoro-1,1,2,2-tetrahydrodecyl)dimethyl-chlorosilane erzeugt ist.

9. Verfahren zur Herstellung eines Substrates zum Tintenstrahldrucken mit einem Grundsubstrat (1) mit einer auf der Grundsubstratoberfläche angeordneten Struktur aus aktiven Bereichen (5) zur Aufnahme von organischem Material zur Ausbildung von Pixeln und aus passiven Bereichen zur Separation der Pixel, **dadurch gekennzeichnet, dass**
zumindest auf einen Teil der passiven Bereiche eine Schicht aus der chemischen Klasse der Organosilane der allgemeinen Formel 1
RₙSiX₄₋ₙ (1)
auf das Grundsubstrat (1) aufgebracht wird, wobei mindestens eine der Gruppen Rₙ eine hydrolisierbare Gruppe und X ein Wasserstoffatom ist.

10. Verfahren nach Anspruch 9, **dadurch gekennzeichnet, dass** die Schicht (4) aus Organosilan nasschemisch aufgebracht wird.

11. Verfahren nach Anspruch 9 oder 10, **dadurch gekennzeichnet, dass** die Oberflächenenergie mittels einer chemischen Modifikation abgesenkt wird.

12. Verfahren nach einem der Ansprüche 9 bis 11, **dadurch gekennzeichnet, dass** die Schicht (4) aus Organosilan mittels eines Lift-Off-Prozesses strukturiert wird.

13. Verfahren nach einem der Ansprüche 9 bis 12, **dadurch gekennzeichnet, dass** als hydrolisierbare Gruppe R aus ein Halogen, Alkoxid, Alkyloxid oder ein Amin verwendet wird.

## Geänderte Patentansprüche

### Geänderte Patentansprüche gemäss Regel 86(2) EPÜ.

**1.** Substrat zum Tintenstrahldrucken bestehend aus einem Grundsubstrat (1) mit einer auf der Grundsubstratoberfläche angeordneten Struktur aus aktiven Bereichen (5) zur Aufnahme von organischem Material zur Ausbildung von Pixeln und aus passiven Bereichen zur Separation der Pixel, **dadurch gekennzeichnet, dass** mindestens ein Teil der passiven Bereiche eine Schicht (4) aus der chemischen Klasse der Organosilane der allgemeinen Formel I
RₙSiX₄₋ₙ (I)
aufweist, wobei 1<=n<=3 gilt und mindestens eine der Gruppen Rₙ eine hydrolisierbare Gruppe und X Fluor oder eine Fluorkohlenwasserstoffkette ist.

**2.** Substrat nach Anspruch 1, **dadurch gekennzeichnet, dass** das Grundsubstrat (1) Glas, Indium-Zinnoxid, Siliziumoxynitrid und/oder Fotolack aufweist.

**3.** Substrat nach Anspruch 1 oder 2, **dadurch gekennzeichnet, dass** die aktiven Bereiche (5) zumindest teilweise mit einer Schicht Indium-Zinnoxid bedeckt sind.

**4.** Substrat nach einem der vorhergehenden Ansprüche, **dadurch gekennzeichnet, dass** die hydrolisierbare Gruppe R aus einem Halogen, Alkoxid, Alkyloxid oder einem Amin besteht.

**5.** Substrat nach einem der vorhergehenden Ansprüche, **dadurch gekennzeichnet, dass** die Schicht (4) aus der chemischen Klasse der Organosilane kovalent an das Grundsubstrat (1) gebunden ist.

**6.** Substrat nach einem der vorhergehenden Ansprüche, **dadurch gekennzeichnet, dass** die Oberflächenenergie der Schicht (4) aus Organosilan kleiner als 40 mJ/m² ist.

**7.** Verfahren zur Herstellung eines Substrates zum Tintenstrahldrucken mit einem Grundsubstrat (1) mit einer auf der Grundsubstratoberfläche angeordneten Struktur aus aktiven Bereichen (5) zur Aufnahme von organischem Material zur Ausbildung von Pixeln und aus passiven Bereichen zur Separation der Pixel, **dadurch gekennzeichnet, dass**
zumindest auf einen Teil der passiven Bereiche eine Schicht aus der chemischen Klasse der Organosilane der allgemeinen Formel 1
RₙSiX₄₋ₙ ((1)
auf das Grundsubstrat (1) aufgebracht wird, wobei 1<=n<=3 gilt und mindestens eine der Gruppen Rₙ eine hydrolisierbare Gruppe und X Fluor oder eine Fluorkohlenwasserstoffkette ist.

**8.** Verfahren nach Anspruch 7, **dadurch gekennzeichnet, dass** die Schicht (4) aus Organosilan nasschemisch aufgebracht wird.

**9.** Verfahren nach Anspruch 7 oder 8, **dadurch gekennzeichnet, dass** die Oberflächenenergie mittels einer chemischen Modifikation abgesenkt wird.

**10.** Verfahren nach einem der Ansprüche 7 bis 9, **dadurch gekennzeichnet, dass** die Schicht (4) aus Organosilan mittels eines Lift-Off-Prozesses strukturiert wird.

**11.** Verfahren nach einem der Ansprüche 7 bis 10, **dadurch gekennzeichnet, dass** als hydrolisierbare Gruppe R aus ein Halogen, Alkoxid, Alkyloxid oder ein Amin verwendet wird.
